Europäisches Patentamt

(19) European Patent Office

Office européen des brevets

(11) EP 0 866 109 A1

(12) EUROPEAN PATENT APPLICATION
published in accordance with Art. 158(3) EPC

(43) Date of publication:
23.09.1998 Bulletin 1998/39

(51) Int. Cl.$^6$: C09J 163/00, H05K 3/34

(21) Application number: 96941169.3

(86) International application number:
PCT/JP96/03554

(22) Date of filing: 04.12.1996

(87) International publication number:
WO 97/20898 (12.06.1997 Gazette 1997/25)

(84) Designated Contracting States:
DE GB

(30) Priority: 06.12.1995 JP 318180/95

(71) Applicant:
MATSUSHITA ELECTRIC INDUSTRIAL CO., LTD.
Kadoma-shi, Osaka 571 (JP)

(72) Inventors:
• MIYAKAWA, Hidenori
  Osaka 570 (JP)

• SUETSUGU, Kenichirou
  Hyogo 662 (JP)
• FUKUSHIMA, Tetsuo
  Osaka 576 (JP)
• OKAWA, Koji
  Osaka 571 (JP)

(74) Representative:
Crawford, Andrew Birkby et al
A.A. THORNTON & CO.
Northumberland House
303-306 High Holborn
London WC1V 7LE (GB)

(54) ADHESIVE, PROCESS FOR THE PREPARATION THEREOF, AND PROCESS FOR MOUNTING COMPONENTS

(57) The invention presents an adhesive not impairing components poor in heat resistance in heating and curing, excellent in storage stability, and free from sagging due to heating.

Comprising 100 parts by weight of an epoxy resin having a content of mononuclear components of 87 to 100% by weight, 20 to 80 parts by weight of a latent curing agent, 2 to 40 parts by weight of an inorganic filler, 1 to 15 parts by weight of a thixotropic agent, and 0.1 to 5 parts by weight of a pigment, the epoxy resin and latent curing agent are preliminarily dispersed, heated, dissolved and cooled, and then the inorganic filler, thixotropic agent and pigment are dispersed to prepare.

EP 0 866 109 A1

Printed by Xerox (UK) Business Services
2.16.3/3.4

**Description**

TECHNICAL FIELD

The present invention relates to an adhesive preferably used in mounting of components such as electronic parts, a process for preparation thereof, and a process for mounting components by using this adhesive.

BACKGROUND ART

As an adhesive suited to mounting of electronic components, an adhesive composed of epoxy resin of standard purity, amine hardener, thixotropic agent, inorganic filler, and pigment is disclosed in Japanese Laid-open Patent No. 1-2493.

Hitherto, when mounting electronic components on a circuit board, a mounting method comprises the steps of applying a mounting adhesive on specified positions on a circuit board, putting electronic components on the applied adhesive positions, heating and curing the adhesive, applying flux on the circuit board, and immersing the circuit board in molten solder to solder and bond the electronic components and the circuit board.

However, the conventional adhesive for mounting electronic components was high in curing temperature and may damage the components poor in heat resistance when curing, and as a countermeasure, conventionally, a large content of amine hardener was mixed in the adhesive for mounting electronic components.

In the existing adhesive for mounting electronic components, nevertheless, if a large content of amine hardener is mixed in, it must be kept within a range for assuring storage stability, and in such a case, yet, the curing temperature is still high, and the components poor in heat resistance may be damaged when curing. Still worse, if a large content of amine hardener is thus blended, the adhesive may sag and spread when heating and curing, and may be adhered to the electrode on the circuit board by this sagging phenomenon due to heating, and when the adhesive is adhered to the electrode, it is hard to solder the electronic component on the electrode.

DISCLOSURE OF THE INVENTION

In the light of the problems of the prior art, therefore, it is an object of the invention to present an adhesive which can be cured at low temperature, does not impair components poor in heat resistance or spoil storage stability, and is free from sagging due to heating, a process for the preparation thereof, and a process for mounting components.

The adhesive of the invention comprises 100 parts by weight of an epoxy resin having a content of mononuclear components of 87 to 100% by weight, and 20 to 80 parts by weight of a latent curing agent. By using the epoxy resin having a high content of mononuclear components, and using the latent curing agent as the hardener, the heating temperature in heating and curing can be lowered by the high content of the hardener, so that the adhesive lowered in the damage rate of components and excellent in storage stability can be obtained.

It further comprises 2 to 40 parts by weight of an inorganic filler, 1 to 15 parts by weight of a thixotropic agent, and 0.1 to 5 parts by weight of a pigment, and therefore the adhesive strength is enhanced and stringing is prevented, so that the adhesive having properties required as the adhesive for mounting components may be obtained.

This adhesive is prepared by preliminarily dispersing, heating, dissolving and cooling the epoxy resin and latent curing agent, and then dispersing the inorganic filler, thixotropic agent and pigment. By defining the heating temperature in heating and dissolving at 30 to 50°C and heating time at 1 to 50 hours, phenomenon of sagging due to heating in heating and curing the adhesive can be prevented.

In the method of mounting components according to the invention, the adhesive comprising 100 parts by weight of the epoxy resin, 20 to 80 parts by weight of the latent curing agent, 2 to 40 parts by weight of the inorganic filler, 1 to 15 parts by weight of the thixotropic agent, and 0.1 to 5 parts by weight of the pigment is prepared, and this method comprises the steps of applying the adhesive on specified positions on the board, putting components on the applied adhesive positions, and heating and curing the adhesive, and it is intended to mount the components without raising the heating and curing temperature. Moreover, when the heating and curing peak temperature in heating and curing is controlled at 100°C or less and the heating time within 30 to 300 seconds, damage of components poor in heat resistance can be prevented.

Besides, after heating and curing the adhesive, by applying flux on the board, the board is immersed in a molten solder, so that the components and board can be soldered and bonded.

BEST MODE OF CARRYING OUT THE INVENTION

According to an embodiment of the invention, an adhesive for mounting components, a process for the preparation thereof, and a process for mounting electronic components by using the same are described below.

The components of the adhesive used herein are as follows.

| | | |
|---|---|---|
| Epoxy resin A: | Epicoat 806L (Yuka Shell Epoxy Co.) (content of mononuclear components 87 to 100% by weight) |
| Epoxy resin B: | Epicoat 828 (Yuka Shell Epoxy Co.) (content of mononuclear components 87% by weight or less) |
| Hardener A: | Fujicure FXE1000 (Fuji Kasei Co.) (aminoureade latent curing agent) |
| Hardener B: | Amicure PN23 (Ajinomoto) (amine curing agent) |
| Inorganic filler: | Mistron CB (Nippon Mistron) |
| Thixotropic agent: | Aerosil RY200 (Nippon Aerosil) |
| Pigment: | Carmine 6B (Dainippon Ink) |

A roll dispersion type agitating machine was used in mixing.

Measuring methods and evaluating methods of characteristics were as follows.

Component damage rate: The adhesive is applied on the circuit board by an adhesive applicator, cylindrical aluminum electrolytic capacitors are mounted by a component mounting machine, the adhesive is heated and cured in a furnace in a profile for curing completely each adhesive, the number of damages (a) in 100 positions of components is counted, and the component damage rate (%) is calculated in the formula $(a/100) \times 100\%$.

Heating sag rate: The adhesive is applied in a circle on the circuit board, the applied diameter $r_0$ [mm] is measured, and it is heated and cured in a furnace, and the applied diameter $r_1$ [mm] is measured, and the heating sag rate (%) is calculated in the formula $\{(r_1-r_0)/r_0\} \times 100\%$.

Damage rate of components poor in heat resistance: The adhesive is applied on the circuit board by an adhesive applicator, LED components are mounted by a component mounting machine, the adhesive is heated and cured in a furnace in a profile for curing completely each adhesive, the number of damages (b) in 100 positions of components is counted, and the damage rate of components poor in heat resistance (%) is calculated in the formula $(b/100) \times 100\%$.

Storage stability: The viscosity $\eta_0$ right after manufacture of the adhesive is measured by type E viscometer, and after leaving the adhesive for 30 days at 25 +/- 1°C, the viscosity $\eta_1$ is measured again, and it is judged if the storage stability approval condition of $(\eta_1/\eta_0) < 2$ is satisfied or not.

First, using 100 parts by weight of epoxy resin A as the adhesive main ingredient, the number of parts by weight of each component that can be blended was studied. The following results were obtained.

As for Mistron CB (Nippon Mistron) as the inorganic filler, the upper limit of an adequate content capable of maintaining properties as adhesive is 40 parts by weight. The minimum content showing effects of addition of inorganic filler is 2 parts by weight.

As for Aerosil YR200 (Nippon Aerosil) as thixotropic agent, the upper limit of an adequate content capable of maintaining properties as adhesive is 15 parts by weight. The minimum content showing effects of addition of thixotropic agent is 1 part by weight.

An adequate content of Carmine 6B (Dainippon Ink) as pigment is 0.1 to 5 parts by weight.

As for the epoxy resin, in the case of Epicoat 807 with the content of mononuclear components of less than 86% by weight, possibility of damage of components is high. It is Epicoat 806L of 86 to 100% by weight that realizes storage stability and other properties and securely presents high effects of prevention of damage of components.

As for the hardener, when Amicure DN23 of amine curing agent is added, the storage stability drops. When the content of Fujicure FXE1000 as latent curing agent is less than 20 parts by weight in 100 parts by weight of epoxy resin, components are damaged, and when exceeding 100 parts by weight, the storage stability declines. An adequate content of the latent curing agent that can realize storage stability and other properties and securely present effects of prevention of damage of components is 20 to 80 parts by weight.

Results of review of manufacturing method are summarized below.

When the epoxy resin and latent curing agent are not preliminarily heated, the heating sag rate is impaired, and therefore it is preferred to perform preliminary heating in order to maintain the heating sag rate in heating and curing within a practical range.

When the preliminary heating temperature of the epoxy resin and latent curing agent exceeds 50°C, the storage stability declines. In order to obtain a sufficient storage stability while maintaining practical properties including heating sag rate, the preliminary heating temperature is preferred to be 30 to 50°C.

Results of review of mounting method of electronic components are summarized below.

If the heating and curing peak temperature of the adhesive exceeds 100°C, components poor in heat resistance may be damaged. To prevent securely damage of components poor in heat resistance in heating and curing of the adhesive, the heating and curing peak temperature must be kept under 100°C.

Embodiments and comparative examples are explained below. Table 1 shows representative embodiment and comparative examples of components. Table 2 shows representative embodiments and comparative examples in the manufacturing process of the adhesive in the composition shown in embodiment 1. Table 3 shows representative embodiment and comparative example of the method of mounting electronic components.

Table 1

|  | Embodiment 1 | Comparative example 1 | Comparative example 2 | Comparative example 3 | Comparative example 4 | Comparative example 5 |
|---|---|---|---|---|---|---|
| Epoxy resin A | 100 | 100 | 100 | 100 | - | - |
| Epoxy resin B | - | - | - | - | 100 | 100 |
| Hardener A | 40 | 15 | 100 | - | 40 | - |
| Hardener B | - | - | - | 40 | - | 40 |
| Inorganic filler | 5 | 5 | 5 | 5 | 5 | 5 |
| Thixotropic agent | 10 | 10 | 10 | 10 | 10 | 10 |
| Pigment | 0.5 | 0.5 | 0.5 | 0.5 | 0.5 | 0.5 |
| (Numerals refer to parts by weight.) | | | | | | |

Table 2

|  | Embodiment 2 | Embodiment 3 | Comparative example 6 | Comparative example 7 |
|---|---|---|---|---|
| Preheating temperature [°C] | 40 | 45 | 25 | 60 |
| Preheating time [hr] | 24 | 0.4 | 0 | 10 |

Table 3

|  | Embodiment 4 | Comparative example 8 |
|---|---|---|
| Heating and curing peak temperature [°C] | 98 | 110 |
| Heating and curing peak time [sec] | 60 | 60 |

Table 4 shows measured results of component damage rate and storage stability in the adhesives in the composition shown in Table 1. Table 5 shows measured results of heating sag rate and storage stability in the manufacturing process of the adhesives shown in Table 2. Table 6 shows measured results of damage rate of components poor in heat resistance in the condition of heating and curing peak temperature and time shown in Table 3.

Table 4

|  | Embodiment 1 | Comparative example 1 | Comparative example 2 | Comparative example 3 | Comparative example 4 | Comparative example 5 |
|---|---|---|---|---|---|---|
| Heating sag rate [%] | 0 | 90 | 0 | 0 | 72 | 67 |
| Storage stability | ○ | ○ | X | X | X | X |

Table 5

| | Embodiment 2 | Embodiment 3 | Comparative example 6 | Comparative example 7 |
|---|---|---|---|---|
| Preheating temperature [%] | 1.0 | 8.2 | 34.7 | 0.3 |
| Storage stability | ○ | ○ | X | X |

Table 6

| | Embodiment 4 | Comparative example 8 |
|---|---|---|
| Damage rate of components poor in heat resistance [%] | 0 | 24 |

These results coincide with the overall review results above relating to the content of mononuclear components of epoxy resin, component of hardener, inorganic filler, thixotropic agent, pigment, preliminary heating temperature and preliminary heating time of epoxy resin and latent curing agent, and peak temperature in heating and curing of adhesive.

INDUSTRIAL APPLICABILITY

The adhesive of the invention, as clear from the description herein, comprises 100 parts by weight of an epoxy resin having a content of mononuclear components of 87 to 100% by weight, and 20 to 80 parts by weight of a latent curing agent. In this constitution, by the combination of the epoxy resin having a high content of mononuclear components and the latent curing agent, a large content of hardener can be blended, and the heating temperature in heating and curing can be lowered, so that the adhesive lowered in the damage rate of components and excellent in storage stability can be obtained.

It further comprises 2 to 40 parts by weight of an inorganic filler, 1 to 15 parts by weight of a thixotropic agent, and 0.1 to 5 parts by weight of a pigment, and therefore the adhesive strength is enhanced and stringing is prevented, so that the adhesive having properties required as the adhesive for mounting components may be obtained.

By preparing the adhesive by preliminarily dispersing, heating, dissolving and cooling the epoxy resin and latent curing agent, and then dispersing the inorganic filler, thixotropic agent and pigment, and further by defining the heating temperature in heating and dissolving at 30 to 50°C and heating time at 1 to 50 hours, sagging due to heating can be prevented, and also time-course changes of the adhesive during storage can be prevented.

In the method of mounting components according to the invention, the adhesive comprising 100 parts by weight of the epoxy resin, 20 to 80 parts by weight of the latent curing agent, 2 to 40 parts by weight of the inorganic filler, 1 to 15 parts by weight of the thixotropic agent, and 0.1 to 5 parts by weight of the pigment is prepared, and by applying the adhesive on specified positions on the board, putting components on the applied adhesive positions, and heating and curing the adhesive, and it is intended to mount the components without raising the heating and curing temperature.

Moreover, when the heating and curing peak temperature in heating and curing is controlled at 100°C or less and the heating time within 30 to 300 seconds, damage of components poor in heat resistance can be prevented.

Besides, after heating and curing the adhesive, by applying flux on the board, the board is immersed in a molten solder, so that the components and board can be soldered and bonded.

**Claims**

1.  An adhesive comprising 100 parts by weight of an epoxy resin having a content of mononuclear components of 87 to 100% by weight, and 20 to 80 parts by weight of a latent curing agent.

2.  An adhesive comprising 100 parts by weight of an epoxy resin having a content of mononuclear components of 87 to 100% by weight, 20 to 80 parts by weight of a latent curing agent, 2 to 40 parts by weight of an inorganic filler, 1 to 15 parts by weight of a thixotropic agent, and 0.1 to 5 parts by weight of a pigment.

3.  A manufacturing method of an adhesive composed of an epoxy resin, a latent curing agent, an inorganic filler, a thixotropic agent, and a pigment, comprising the steps of preliminarily dispersing, heating, dissolving and cooling the epoxy resin and latent curing agent, and then dispersing the inorganic filler, thixotropic agent and pigment.

4. A manufacturing method of an adhesive of claim 3, wherein the heating temperature in heating and dissolving is 30 to 50°C and the heating time is 1 to 50 hours,

5. A manufacturing method of an adhesive of claim 3 or 4, wherein said adhesive comprises 100 parts by weight of the epoxy resin, 20 to 80 parts by weight of the latent curing agent, 2 to 40 parts by weight of the inorganic filler, 1 to 15 parts by weight of the thixotropic agent, and 0.1 to 5 parts by weight of the pigment.

6. A mounting method of components comprising the steps of preparing an adhesive composed of 100 parts by weight of an epoxy resin, 20 to 80 parts by weight of a latent curing agent, 2 to 40 parts by weight of an inorganic filler, 1 to 15 parts by weight of a thixotropic agent, and 0.1 to 5 parts by weight of a pigment, applying the adhesive on specified positions on a board, putting components on the applied adhesive positions, and heating and curing the adhesive.

7. A mounting method of components of claim 6, wherein the heating and curing peak temperature of the adhesive is 100°C or less, and the heating time is 30 to 300 seconds.

8. A mounting method of components of claim 6 or 7, further comprising the steps of, after heating and curing the adhesive, applying flux on the board, immersing the board in a molten solder, and soldering and bonding the components and the board.

# INTERNATIONAL SEARCH REPORT

| | International application No. |
|---|---|
| | PCT/JP96/03554 |

**A. CLASSIFICATION OF SUBJECT MATTER**

Int. Cl$^6$  C09J163/00, H05K3/34

According to International Patent Classification (IPC) or to both national classification and IPC

**B. FIELDS SEARCHED**

Minimum documentation searched (classification system followed by classification symbols)

Int. Cl$^6$  C09J163/00, H08K3/34

Documentation searched other than minimum documentation to the extent that such documents are included in the fields searched

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| P | JP, 8-170062, A (Matsushita Electric Industrial Co., Ltd.), July 2, 1996 (02. 07. 96), Claim (Family: none) | 1, 2 |
| A | JP, 7-316400, A (Somar Corp.), December 5, 1995 (05. 12. 95), Claim & GB, 2287940, A & US, 5585421, A | 1 - 8 |
| A | JP, 4-33916, A (Somar Corp.), February 5, 1992 (05. 02. 92), Claim & EP, 459614, A1 | 1 - 8 |
| A | JP, 63-156817, A (Matsushita Electric Works, Ltd.), June 29, 1988 (29. 06. 88), Claim (Family: none) | 1 - 8 |
| A | JP, 5-59158, A (Sumitomo Bakelite Co., Ltd.), March 9, 1993 (09. 03. 93), Claim (Family: none) | 1 - 8 |

[X] Further documents are listed in the continuation of Box C.     [ ] See patent family annex.

| | |
|---|---|
| *   Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| February 13, 1997 (13. 02. 97) | February 25, 1997 (25. 02. 97) |

| Name and mailing address of the ISA/ | Authorized officer |
|---|---|
| Japanese Patent Office | |
| Facsimile No. | Telephone No. |

Form PCT/ISA/210 (second sheet) (July 1992)

## INTERNATIONAL SEARCH REPORT

| International application No. |
|---|
| PCT/JP96/03554 |

C (Continuation).  DOCUMENTS CONSIDERED TO BE RELEVANT

| Category* | Citation of document, with indication, where appropriate, of the relevant passages | Relevant to claim No. |
|---|---|---|
| P | JP, 8-53659, A (Fujitsu Ltd.),<br>February 27, 1996 (27. 02. 96),<br>Claim (Family: none) | 1 - 8 |

Form PCT/ISA/210 (continuation of second sheet) (July 1992)